# EUROPÄISCHE PATENTSCHRIFT

(11) **EP 1 348 974 B1**
(45) Veröffentlichungstag und Bekanntmachung des Hinweises auf die Patenterteilung: **14.03.2012**
(21) Anmeldenummer: 03001517.6
(22) Anmeldetag: 23.01.2003
(51) Int. Cl.: G01R 33/022

(54) **Sensorelement und Gradiometeranordnung, deren Verwendung zum Messen von Magnetfeldgradienten und Verfahren hierzu**
Sensor element and gradiometer device, application to measuring magnetic field gradients and corresponding method
Elément capteur et dispositif de mesure des gradients, application à la mesure des gradients magnétique et méthode correspondante

(30) Priorität: 28.03.2002 DE 10213941
(43) Veröffentlichungstag der Anmeldung: 01.10.2003
(73) Patentinhaber: ROBERT BOSCH GMBH, 70442 Stuttgart (DE)
(72) Erfinder: Herrmann, Ingo, 70771 Leinfelden-Echterdingen (DE); Siegle, Henrik, 71229 Leonberg (DE)

(56) Entgegenhaltungen:
- EP-A2- 0 730 162
- DE-A1- 4 335 826
- JP-A- 5 249 210

## Beschreibung

Die Erfindung betrifft ein Sensorelement und eine Gradiometeranordnung zur Messung von Magnetfeldgradienten, sowie ein Verfahren zur Messung von Magnetfeldgradienten mit einem solchen Sensorelement oder einer solchen Gradiometeranordnung, nach der Gattung der unabhängigen Ansprüche.

### Stand der Technik

Magnetsensoren finden breiten Einsatz in Kraftfahrzeugen, beispielsweise als Drehzahlfühler am Rad, als Drehzahl- bzw. Fahrtengeber für die Motorsteuerung oder als Lenkwinkelsensor für Fahrdynamikregelungen. Weiter werden Magnetsensoren auch in der Stromsensorik, beispielsweise für das elektrische Batteriemanagement von Kraftfahrzeugen, eingesetzt. Dabei tritt das Problem auf, dass die auftretenden Ströme sehr unterschiedlich sind, so dass die Sensoren Magnetfeldgradienten über mindestens fünf Größenordnungen erfassen können müssen, und dass bisher keine Technologie verfügbar ist, die diesen Messbereich mit einem Sensorelement abdecken kann. Insofern ist bisher eine kostenintensive Anordnung von mehreren Sensoren erforderlich, die unterschiedliche Messbereiche abdecken.

Magnetoresistive Sensorelemente auf Grundlage der GMR-Technologie ("Giant Magneto Resistance") und auch der AMR-Technologie ("Anisotropic Magneto Resistance"), die entweder nach dem Prinzip gekoppelter Multilagen-Schichtsysteme oder nach dem Prinzip von Spin-Valve-Schichtsysternen arbeiten, und damit aufgebaute Gradiometeranordnungen sind aus dem Stand der Technik grundsätzlich bekannt. Dazu sei beispielsweise auf die Anmeldung DE 101 28 135.8 verwiesen, die magnetoresistive Schichtanordnungen und Gradiometer mit solchen Schichtanordnungen auf Basis der GMR- oder AMR-Technologie ausführlich erläutert sind. Einen Überblick über magnetoresistive Sensorelemente gibt zudem U. Dibbern in "Sensors - A Comprehensive Survey", herausgegeben von W. Göpel et al., Band 5, MagneLic Sensors, VCH-Verlag, Weinheim, 1989, Seiten 342 bis 380.

Die offeneigunqsschrift DE 43 35 826 A1 offenbart eine Vorrichtung zur Messung inhomogener Magnetfelder die zwei parallelgeschaltele Brückenzweige einer Bruckenschaltung (3) mit jeweils zwei magnetoresistiven Sensoreinrichtungen enthält. Die Sensoreinrirhtungen weisen vorbestimmte Vorzeichen ihrer magnetfeldabhängigen Witierstandsänderungen haben. Alle Sensoreinrichtungen der Brückenschaltung sollene derart nebeneinander angeordnet sein, daß die äußeren Sensoreinrichtungen zu verschiedenen Brückenzweigen gehören. Des Weiteren haben die Sensoreinrichtungen an die Inhomogeität des Magnetfelds angepaßte Empfindlichkeiten.

Die JP 052-19210 befasst sich mit einem magnetischen Sensor der ein erstes magnetoresistives Element, sowie ein zweites magnetoreistives Element zur Temperaturkompensation aufweist. Die Breite des zweiten Elements ist dabei geringer als die des ersten Elements.

nie EP 0 730 162 A2 befasst sich mit einer Sensoreinrichtung die eine Brückenschaltung von magnetoresistiven Sensorelementen aufweist. Jedes diesen Sensorelemente soll den gleichen Schichtaufbau besitzen und auf einem gemeinsamen Trägerelement angeordnet sein. Mindestens eines der Sensorelemente weist eine gegenüber den anderen Sensorelementen unterschiedliche Empfindlichkeit auf, indem es eine abweichende Geometrie bzw. Grundfläche aufweist.

Aufgabe der vorliegenden Ereindung war die Bereitstellung eines Sensorelementes bzw. einer Gradiometeranordnung das bzw. die es erlaubt, Magnetfeldgradienten über einen mög lichst großen Messbereich mit einem einzigen Sensorelement zu erfassen. Insbesondere war es Aufgabe, mit einem solchen Sensorelement oder einer solchen Gradiometeranordnung Magnetfeldgradienten über mindestens fünf Größenordnungen bei typischen magnetischen Feldstärken zwischen 1 µT und 30 mT, insbesondere von 1 µT bis 10 mT, zu messen.

### Vorteile der Erfindung

Das erfindungsgemäße Sensorelement: und die erfindungsgemäße Gradiometeranordnung hat gegenüber dem Stand der Technik den Vorteil, dass damit Magnetfeldgradienten über einen sehr weiten Messbereich erfassbar sind. Weiter ist vorteilhaft, "dass bei einer Mehrzahl von magnetoresistiven Schichtanordnungen, die jeweils zumindest bereichsweise, insbesondere möglichst vollständig, streifenförmig strukturiert sind, ei ne unterschiedliche Breite der Streifen dieser magnetoresistiven Schichtanordnungen gezielt so einstellbar ist, dass hinsichtlich des Messbereiches des insgesamt erhaltenen Sensorelementes oder der insgesamt erhaltenen Gradiometeranordnung für den zu messenden Magnetfeldgradienten ein über den Einzelmessbereich einer einzelnen Schichtanordnung hinausgehender Gesamtmessbereich der mehreren Schichtanordnungen erhalten wird.

Daneben ist gegenüber dem Stand der Technik vorteilhaft, dass das erfindungsgemäße Sensorelement und die erfindungsgemäße Gradiometeranordnung sehr kompakt aufbaubar bzw. unter Beanspruchung eines sehr kleinen Bauraumes auf einem gemeinsamen Sensorchip integrierbar ist. Dies führt insbesondere zu einem geringen Aufwand für die Verpackung des Sensorelementes bzw. der Gradiometeranordnung und zu deutlich verringerten Fertigungs- und Montagekosten.

Schließlich hat sich bei dem erfindungsgemäßen Sensorelement und der erfindungsgemäßen Gradiometeranordnung vorteilhaft herausgestellt, dass sich vor allem bei magnetoresisitiven Schichtsystemen auf Grundlage des GMR-Effektes, die nach dem Spin-Valve-Prinzip arbeiten, die Steilheit der Kennlinie der magnetoresistiven Schichtanordnung, d.h. die Änderung des elektrischen Widerstandes in der Zwischenschicht als Funktion der Änderung eines von außen anliegenden Magnetfeldes, und damit auch der Arbeitsbereich bzw. der Einzelmessbereich und die Empfindlichkeit der magnetoresistiven Schichtanordnung sehr einfach über die Breite des Streifens, zu dem die Schichtanordnung in Draufsicht strukturiert bzw. ausgebildet ist, einstellen lässt.

Dabei sei betont, dass es prinzipiell genügt, wenn die Schichtanordnung in Draufsicht zumindest bereichsweise streifenförmig ausgebildet ist, bevorzugt ist sie jedoch zumindest weitgehend oder vollständig streifenförmig ausgebildet, worunter auch Mäander zu verstehen sind, die zumindest abschnittweise streifenförmig ausgebildet sind.

Es ist somit nun möglich, auf einem gemeinsamen Substrat oder einem gemeinsamen Sensorchip mehrere, miteinander verschaltete magnetoresistive Schichtanordnungen aufzubringen, die unterschiedliche Strukturbreiten, bzw. Streifenbreiten und somit unterschiedliche Empfindlichkeiten und Arbeitsbereiche aufweisen, so dass sich ein vergrößerter Gesamtmessbereich ergibt.

Vorteilhafte Weiterbildungen der Erfindung ergeben sich aus den in den Unteransprüchen genannten Maßnahmen.

So ist es besonders vorteilhaft, wenn die Streifen eine Breite im Bereich von 0,5 µm bis 200 µm, insbesondere von 1 µm bis 100 µm, aufweisen.

Als besonders vorteilhaft hat sich weiter herausgestellt, wenn das Sensorelement zwei oder bevorzugt drei magnetoresistive Schichtanordnungen aufweist, wobei eine erste magnetoresistive Schichtanordnung streifenförmig strukturiert ist mit einer ersten Streifenbreite, die im Bereich zwischen 0,5 µm und 2µm liegt, wenn eine zweite magnetoresistive Schichtanordnung streifenförmig strukturiert ist mit einer zweiten Streifenbreite, die im Bereich zwischen 8 µm und 15 µm liegt, und wenn eine dritte magnetoresistive Schichtanordnung streifenförmig strukturiert ist mit einer dritten Streifenbreite, die im Bereich zwischen 3 um und 7 µm liegt. Auf diese Weise lassen sich besonders gut Magnetfeldgradienten über mindestens fünf Größenordnungen bei typischen Feldern um 5 mTesla messen.

Vorteilhaft ist weiter, wenn im Fall des erfindungsgemäßen Sensorelementes bzw. im Fall der erfindungsgemäßen Gradiometeranordnung auf dem Substrat mit den magnetoresistiven Schichtanordnungen gleichzeitig auch eine damit verschaltete elektrische Auswerteeinheit vorgesehen ist. Diese kann jedoch auch außerhalb des gemeinsamen Substrates angeordnet sein, was aber das Vorsehen von Signalausgängen bzw. Schnittstellen und eine größere Bauform erfordert.

Eine besonders einfache und vorteilhafte Gradiometeranordnung ergibt sich schließlich, wenn zwei oder bevorzugt drei Gradiometervollbrücken auf dem gemeinsamen Substrat vorgesehen sind, wobei jede dieser Gradiometervollbrücken insbesondere vier nach Art einer Wheatstone-Brücke verschaltete magnetoresistive Schichtanordnungen aufweist, wobei die Streifenbreiten innerhalb dieser zu einer Wheatstone-Brücke verschalteten magnetoresistiven Schichtanordnungen bevorzugt gleich sind, und wobei sich die Streifenbreiten zwischen den verschiedenen Wheatstone-Brückenschaltungen zugeordneten magnetoresistiven Schichtanordnungen jeweils unterscheiden.

### Zeichnungen

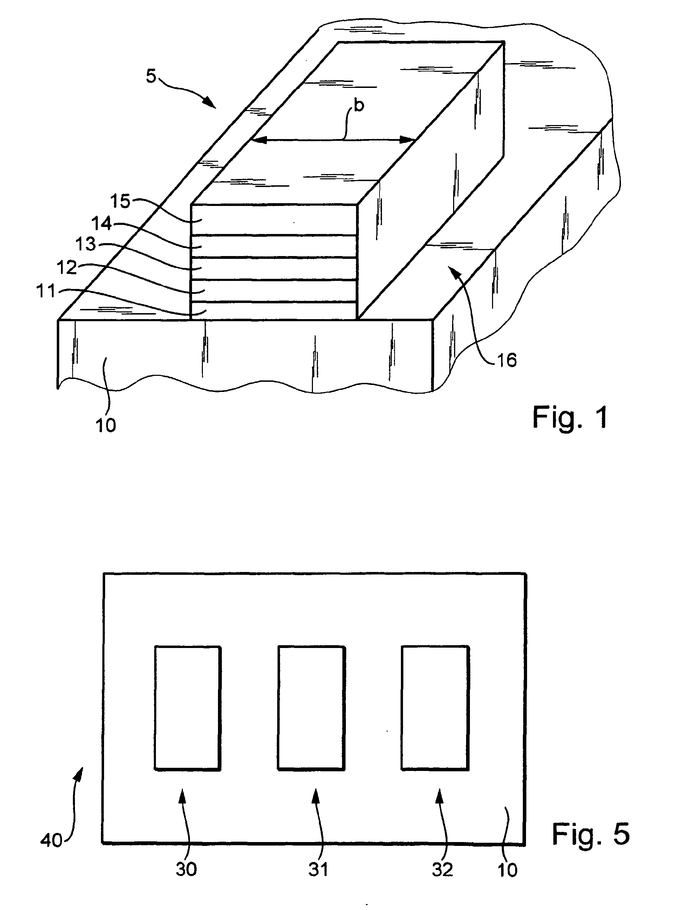

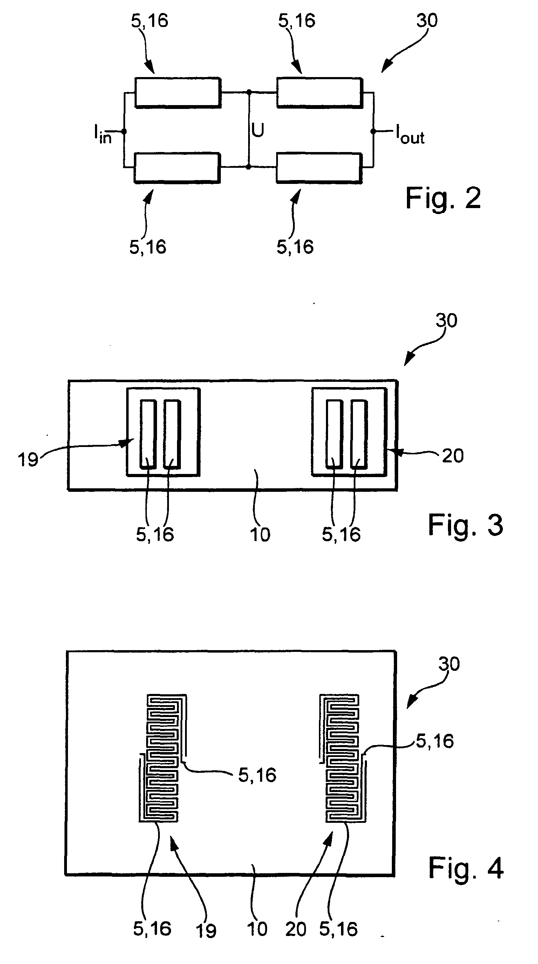

Die Erfindung wird anhand der Zeichnungen und nachfolgenden Beschreibung näher erläutert. Es zeigt Figur 1 eine perspektivische Darstellung einer magnetoresistiven Schichtanordnung auf einem Substrat, Figur 2 eine Prinzipskizze einer Wheatstone-Brückenschaltung mit vier magnetoresisitiven Schichtanordnungen gemäß Figur 1, Figur 3 eine Prinzipskizze eines Gradiometers mit einer Gradiometervollbrücke, Figur 4 eine Detaildarstellung von Figur 3 mit mäanderförmigen magnetoresistiven Schichtanordnungen und Figur 5 eine Anordnung von mehreren Gradiometervollbrücken bzw. Gradiometern gemäß Figur 4 auf einem gemeinsamen Substrat zu einer Gradiometeranordnung.

### Ausführungsbeispiele

Die Erfindung geht zunächst von einer in Figur 1 dargestellten, an sich bekannten magnetoresistiven Schichtanordnung 5 auf Grundlage des GMR-Effektes aus, die nach dem Spin-Valve-Prinzip arbeitet.

Im Einzelnen ist gemäß Figur 1 ein Substrat 10 vorgesehen, auf dem sich bereichsweise eine Anpassschicht 11 ("Bufferschicht"), beispielsweise aus Eisen oder Nickel-Eisen, befindet. Auf der Anpassschicht 11 ist eine Referenzschicht 12, deren Richtung der Magnetisierung zumindest weitestgehend unabhängig von der Richtung eines äußeren Magnetfeldes ist, angeordnet. Die Referenzschicht 12 besteht bevorzugt aus zwei Teilschichten, beispielsweise einer antiferromagnetischen Schicht aus Nickeloxid mit einer Dicke von beispielsweise 50 nm und einer weichmagnetischen Schicht aus Nickel-Eisen mit einer Dicke von beispielsweise 5 nm. Auf der Referenzschicht 12 befindet sich dann weiter eine nichtmagnetische, elektrisch leitfähige Zwischenschicht 13, beispielsweise aus Kupfer. Auf der Zwischenschicht 13 ist eine weichmagnetische Detektionsschicht 14 angeordnet, deren Richtung der Magnetisierung sich zumindest näherungsweise parallel zu der Richtung eines äußeren Magnetfeldes orientiert, so dass sich über den GMR-Effekt als Funktion des Winkels zwischen der Richtung der Magnetisierung in der Referenzschicht 12 und der Richtung der Magnetisierung in der Detektionsschicht 14 eine Änderung des elektrischen Widerstandes in der Zwischenschicht 13 ergibt. Die Detektionsschicht 14 ist beispielsweise eine weichmagnetische Nickel-Eisen-Schicht mit einer Dicke von 5 nm. Auf der Detektionsschicht 14 befindet sich abschließend eine Deckschicht 15, die beispielsweise aus Tantal besteht.

Die magnetoresistive Schichtanordnung 5 auf dem Substrat 10 ist gemäß Figur 1 in Draufsicht streifenförmig strukturiert, wobei der in Draufsicht sichtbare Streifen 16 eine Breite b aufweist, die zwischen 0,5 µm und 200 µm, insbesondere zwischen 1 µm und 100 µm, liegt.

Die Figur 2 zeigt, wie vier magnetoresistive Schichtanordnungen 5 gemäß Figur 1, die sich auf dem gemeinsamen Substrat 10 befinden, zu einer Wheatstone-Brücke miteinander verschaltet sind, so dass sich ein erstes Gradiometer 30 ergibt. Insbesondere ist im Fall von Figur 2 vorgesehen, dass die magnetoresistiven Schichtanordnungen 5 jeweils in Form von gleich breiten Streifen 16 strukturiert sind, die jeweils eine Streifenbreite b aufweisen, wobei darunter auch mäanderförmig strukturierte magnetoresistive Schichtanordnungen 5 zu verstehen sind.

Figur 3 zeigt in Weiterführung der Prinzipskizze gemäß Figur 2, wie auf dem Substrat 10 die Wheatstone-Brückenschaltung in eine erste Halbbrücke 19 und eine zweite Halbbrücke 20 gegliedert ist, die räumlich nebeneinander angeordnet sind, wobei die erste Halbbrücke 19 und die zweite Halbbrücke 20 gemäß Figur 2 zu einer Vollbrücke miteinander verschaltet sind. Weiter weist sowohl die erste Halbbrücke 19 als auch die zweite Halbbrücke 20 jeweils zwei magnetoresistive Schichtanordnungen 5 gemäß Figur 1 auf, die jeweils in Fomr von Strifen 16 mit einer Streifenbreite b strukturiert sind.

Die Figur 4 zeigt eine präzisere Darstellung der ersten Halbbrücke 19 bzw. der zweiten Halbbrücke 20 gemäß Figur 3, so dass erkennbar ist, dass die magnetoresistiven Schichtanordnungen 5 gemäß Figur 3 jeweils in Form von mäanderförmigen, eng benachbarten magnetoresistiven Schichtanordnungen 5 ausgeführt sind.

Weitere Details zum Aufbau der magnetoresistiven Schichtanordnung 5 und deren Verschaltung zu einer Wheatstone-Brücke bzw. zu einem Gradiometer 30 sind in DE 101 28 135.8 ausführlich erläutert, so dass auf diese Details hier nicht weiter eingegangen werden muss.

Die Figur 5 zeigt ein Sensorelement in Form einer Gradiometeranordnung 40 mit insgesamt drei Gradiometern bzw. Gradiometervollbrücken, einem ersten Gradiometer 30, einem zweiten Gradiometer 31 und einem dritten Gradiometer 32, die auf dem gemeinsamen Substrat 10 zu der Gradiometeranordnung 40 miteinander verschaltet sind. Bevorzugt ist auf dem Substrat 10 auch noch eine nicht dargestellte elektrische Auswerteeinheit vorgesehen.

Die einzelnen Gradiometer 30, 31, 32 sind prinzipiell gleich und jeweils entsprechend Figur 2, Figur 3 oder Figur 4 aufgebaut. Sie unterscheiden sich lediglich dadurch, dass die sie in Draufsicht jeweils bildenden streifenförmigen magnetoresistiven Schichtanordnungen 5 innerhalb eines Gradiometers 30, 31, 32 jeweils gleiche aber von Gradiometer zu Gradiometer jeweils unterschiedliche Streifenbreiten aufweisen.

So beträgt die Streifenbreite b gemäß Figur 1 bei dem ersten Gradiometer 30, d.h. jedem der dieses Gradiometer bildenden magnetoresistiven Schichtanordnungen 5 gemäß Figur 1, beispielsweise 0,5 µm bis 2 µm, bei dem zweiten Gradiometer 31 entsprechend beispielsweise 3 µm bis 7 µm, und bei dem dritten Gradiometer 32 entsprechend beispielsweise 8 µm bis 15 µm.

Die Streifenbreiten sind so gewählt, dass sich die Einzelmessbereiche der einzelnen Gradiometer 30, 31, 32 zu einem darüber hinaus gehenden Gesamtmessbereich der Gradiometeranordnung 40 zusammensetzen.

Insbesondere beruht die Anordnung 40 auf der Erkenntnis, dass bei geringen Streifenbreiten von beispielsweise 1,5 µm die Änderung des elektrischen Widerstandes als Funktion eines sich ändernden Magnetfeldes eine geringere Steigung aufweist als bei einer größeren Streifenbreite von beispielsweise 10 µm.

Weiter nimmt die Widerstandsänderung pro Magnetfeldänderung mit der Streifenbreite innerhalb gewisser Grenzen zu, so dass es vorteilhaft ist, mehrere Gradiometer 30, 31, 32 auf dem gemeinsamem Substrat 10 anzuordnen, die deutlich voneinander verschiedene Streifenbreiten aufweisen, und die so unterschiedliche Messbereiche abdecken.

Zur optimalen Anpassung der Gradiometeranordnung 40 an den gewünschten Messbereich für einen Magnetfeldgradienten ist es somit ausreichend, die Widerstandsänderung als Funktion der Magnetfeldänderung für verschiedene magnetoresistive Schichtanordnungen 5 gemäß Figur 1 aufzunehmen, und anschließend aus diesen Messkurven die für den Einzelfall, d.h. den gewünschten Messbereich für einen Magnetfeldgradienten, optimale Kombination aus Gradiometern 30, 31, 32 mit jeweils zugehörigen Streifenbreiten zusammenzustellen.

Dabei kann es je nach Einzelfall genügen, lediglich zwei Gradiometer auf dem Substrat 10 anzuordnen, es aber auch erforderlich sein, abweichend von Figur 5, eine über drei hinausgehende Zahl von Gradiometern 30, 31, 32 vorzusehen.

Insgesamt ist es eine wesentliche Erkenntnis der vorliegenden Erfindung, dass sich die Kennliniensteilheit bei magnetoresistiven Schichtsystemen auf der Grundlage des GMR-Effektes, die insbesondere nach dem Spin-Valve-Prinzip arbeiten, in Abhängigkeit von der Strukturbreite der streifenförmigen Strukturen verändern und gezielt einstellen lässt.

## Patentansprüche

1. Gradiometeranordnung mit wenigstens zwei Gradiometerbrücken (30, 31, 32) mit insbesondere jeweils vier nach Art einer Wheatstone-Brücke verschalteten magnetoresistiven Schichtanordnungen (5), die in Draufsicht zumindest bereichsweise als Streifen (16) mit einer jeweils innerhalb eines Gradiometers gleichen Streifenbreite (b) ausgebildet sind, wobei die Schichtanordnungen von Gradiometer zu Gradiometer jeweils unterschiedliche Streifenbreiten aufweisen, wobei die Gradiometerbrücken (30, 31) auf einem gemeinsamen Substrat (10) angeordnet sind.

2. Gradiometeranordnung nach Anspruch 1, wobei die Streifenbreiten der Schichtanordnungen so gewählt sind, dass die Einzelmessbereiche der einzelnen Gradiometer sich zu einem darüber hinausgehenden Gesamtmessbereich der Gradiometeranordnung zusammensetzen.

3. Gradiometeranordnung nach Anspruch 1, mit einer ersten Gradiometerbrücke (30) mit insbesondere vier nach Art einer Wheatstone-Brücke verschalteten ersten magnetoresistiven Schichtanordnungen (5), die in Draufsicht jeweils zumindest bereichsweise als Streifen (16) mit einer ersten Streifenbreite (b) ausgebildet sind, einer zweiten Gradiometerbrücke (31) mit insbesondere vier nach Art einer Wheatstone-Brücke verschalteten zweiten magnetoresistiven Schichtanordnungen, die in Draufsicht jeweils zumindest bereichsweise als Streifen mit einer von der ersten Streifenbreite (b) verschiedenen zweiten Streifenbreite ausgebildet sind, und einer dritten Gradiometerbrücke (32) mit insbesondere vier nach Art einer Wheatstone-Brücke verschalteten magnetoresistiven Schichtanordnungen, die in Draufsicht jeweils zumindest bereichsweise als Streifen mit einer von der ersten und der zweiten Streifenbreite verschiedenen dritten Streifenbreite ausgebildet sind, und wobei die Gradiometerbrücken (30, 31, 32) auf einem gemeinsamen Substrat (10) angeordnet sind.

4. Gradiometeranordnung nach Anspruch 1 mit einer ersten Gradiometerbrücke (30) mit insbesondere vier nach Art einer Wheatstone-Brücke verschalteten ersten magnetoresistiven Schichtanordnungen (5), die in Draufsicht jeweils zumindest bereichsweise als Streifen (16) mit einer ersten Streifenbreite (b) ausgebildet sind, und einer zweiten Gradiometerbrücke (31) mit insbesondere vier nach Art einer Wheatstone-Brücke verschalteten zweiten magnetoresistiven Schichtanordnungen, die in Draufsicht jeweils zumindest bereichsweise als Streifen mit einer von der ersten Streifenbreite (b) verschiedenen zweiten Streifenbreite ausgebildet sind, wobei die Gradiometerbrücken (30, 31) auf einem gemeinsamen Substrat (10) angeordnet sind.

5. Gradiometeranordnung nach Anspruch 1, **dadurch gekennzeichnet, dass** die Streifen eine Streifenbreite im Bereich von 0,5 µm bis 200 µm, insbesondere von 1 µm bis 100 µm, aufweisen.

6. Gradiometeranordnung nach Anspruch 4, **dadurch gekennzeichnet, dass** die erste Streifenbreite (b) zwischen 0,5 µm und 2 µm oder zwischen 8 µm und 15 µm ausgewählt ist, und dass die zweite Streifenbreite zwischen 3 µm und 7 µm ausgewählt ist.

7. Gradiometeranordnung nach Anspruch 3, **dadurch gekennzeichnet, dass** die erste Streifenbreite (b) zwischen 0,5 µm und 2 µm, die zweite Streifenbreite zwischen 8 µm und 15 µm und die dritte Streifenbreite zwischen 3 µm und 7 µm ausgewählt ist.

8. Gradiometeranordnung nach einem der vorangehenden Ansprüche, **dadurch gekennzeichnet, dass** eine gemeinsame, mit den magnetoresistiven Schichtanordnungen verschaltete elektrische Auswerteeinheit vorgesehen ist, die insbesondere ebenfalls auf dem Substrat (10) angeordnet ist.

9. Gradiometeranordnung nach Anspruch 1, **dadurch gekennzeichnet, dass** die magnetoresistiven Schichtanordnungen jeweils auf Basis des GMR-Effektes oder des AMR-Effektes unter Verwendung von gekoppelten Multilagen oder nach dem Spin-Valve-Prinzip arbeiten.

10. Gradiometeranordnung nach Anspruch 1, **dadurch gekennzeichnet, dass** die Schichtanordnungen jeweils in Draufsicht zumindest weitgehend streifenförmig und insbesondere in Form von Streifenmäandem ausgebildet sind.

11. Verfahren zur Messung von Magnetfeldgradienten mit einem Sensorelement, insbesondere einer Gradiometeranordnung, nach einem der vorangehenden Ansprüche, wobei eine Mehrzahl von Gradiometerbrücken (30, 31, 32) mit magnetoresistiven Schichtanordnungen auf einem gemeinsamen Substrat erzeugt wird, wobei die Schichtanordnungen jeweils zumindest bereichsweise als Streifen ausgebildet sind, wobei sich die Breite der Streifen bei mindestens zwei der Streifen mindestens zweier Schichtanordnungen von voneinander verschiedener Gradiometerbrücken unterscheidet, und wobei die unterschiedliche Einstellung der Breite der Streifen bei deren Erzeugung derart erfolgt, dass hinsichtlich des Messbereiches des Sensorelementes für den Magnetfeldgradienten ein über den Einzelmessbereich einer einzelnen Gradiometerbrücke hinausgehender Gesamtmessbereich der mehreren Gradiometerbrücken erhalten wird

12. Verfahren nach Anspruch 11 **dadurch gekennzeichnet, dass** zur Vergrößerung des Gesamtmessbereiches mindestens drei Gradiometerbrücken mit drei voneinander verschiedenen Streifenbreiten eingesetzt werden, und dass die Einzelmessbereiche über eine Anpassung der Streifenbreiten derart eingestellt werden, dass sich ein gewünschter Gesamtmessbereich ergibt.

## Claims

1. Gradiometer arrangement comprising at least two gradiometer bridges (30, 31, 32) comprising, in particular, in each case four magnetoresistive layer arrangements (5) interconnected in the manner of a Wheatstone bridge, which, in plan view, at least in regions, are embodied as strips (16) having a strip width (b) that is in each case identical within a gradiometer, wherein the layer arrangements have different strip widths in each case from gradiometer to gradiometer, wherein the gradiometer bridges (30, 31) are arranged on a common substrate (10).

2. Gradiometer arrangement according to Claim 1, wherein the strip widths of the layer arrangements are chosen such that the individual measurement ranges of the individual gradiometers combine to form a total measurement range of the gradiometer arrangement that goes beyond them.

3. Gradiometer arrangement according to Claim 1, comprising a first gradiometer bridge (30) comprising, in particular, four first magnetoresistive layer arrangements (5) interconnected in the manner of a Wheatstone bridge, which, in plan view, in each case at least in regions, are embodied as strips (16) having a first strip width (b), a second gradiometer bridge (31) comprising, in particular, four second magnetoresistive layer arrangements interconnected in the manner of a Wheatstone bridge, which, in plan view, in each case at least in regions, are embodied as strips having a second strip width, which is different from the first strip width (b), and a third gradiometer bridge (32) comprising, in particular, four magnetoresistive layer arrangements interconnected in the manner of a Wheatstone bridge, which in plan view, in each case at least in regions, are embodied as strips having a third strip width, which is different from the first and second strip widths, and wherein the gradiometer bridges (30, 31, 32) are arranged on a common substrate (10).

4. Gradiometer arrangement according to Claim 1, comprising a first gradiometer bridge (30) comprising, in particular, four first magnetoresistive layer arrangements (5) interconnected in the manner of a Wheatstone bridge, which, in plan view, in each case at least in regions, are embodied as strips (16) having a first strip width (b), and a second gradiometer bridge (31) comprising, in particular, four second magnetoresistive layer arrangements interconnected in the manner of a Wheatstone bridge, which, in plan view, in each case at least in regions, are embodied as strips having a second strip width, which is different from the first strip width (b), wherein the gradiometer bridges (30, 31) are arranged on a common substrate (10).

5. Gradiometer arrangement according to Claim 1, **characterized in that** the strips having a strip width in the range of 0.5 µm to 200 µm, in particular of 1 µm to 100 µm.

6. Gradiometer arrangement according to Claim 4, **characterized in that** the first strip width (b) is chosen to be between 0.5 µm and 2 µm or between 8 µm and 15 µm and **in that** the second strip width is chosen to be between 3 µm and 7 µm.

7. Gradiometer arrangement according to Claim 3, **characterized in that** the first strip width (b) is chosen to between 0.5 µm and 2 µm, the second strip width is chosen to be between 8 µm and 15 µm, and the third strip width is chosen to be between 3 µm and 7 µm.

8. Gradiometer arrangement according to .any of the preceding claims, **characterized in that** a common electrical evaluation unit interconnected with the magnetoresistive layer arrangements is provided, which, in particular, is likewise arranged on the substrate (10).

9. Gradiometer arrangement according to Claim 1, **characterized in that** the magnetoresistive layer arrangements in each case operate on the basis of the GMR effect or the AMR effect using coupled multilayers or according to the spin valve principle.

10. Gradiometer arrangement according to Claim 1, **characterized in that** the layer arrangements are in each case embodied, in plan view, at least substantially in strip form and in particular in the form of strip meanders.

11. Method for measuring magnetic field gradients with a sensor element, in particular a gradiometer arrangement, according to any of the preceding claims, wherein a plurality of gradiometer bridges (30, 31, 32) comprising magnetoresistive layer arrangements are produced on a common substrate, wherein the layer arrangements are in each case embodied as strips at least in regions, wherein the width of the strips differs in the case of at least two of the strips of at least two layer arrangements of mutually different gradiometer bridges, and wherein the different setting of the width of the strips is effected during the production thereof in such a way that, with regard to the measurement range of the sensor element for the magnetic field gradient, a total measurement range of the plurality of gradiometer bridges that goes beyond the individual measurement range of an individual gradiometer bridge is obtained.

12. Method according to Claim 11, **characterized in that** at least three gradiometer bridges having three mutually different strip widths are used for increasing the total measurement range, and **in that** the individual measurement ranges are set via an adaptation of the strip widths in such a way that a desired total measurement range results.

## Revendications

1. Système gradiométrique présentant au moins deux ponts gradiométriques (30, 31, 32) dotés en particulier chacun de quatre systèmes magnétorésistifs stratifiés (5) raccordés en pont de Wheatstone, dont au moins certaines parties de chacun, vues en plan, sont configurées comme rubans (16) qui présentent chacun une même largeur (b) l'intérieur d'un gradiomètre, les systèmes stratifiés présentant chacun une largeur différente de ruban d'un gradiomètre à l'autre, les ponts gradiométriques (30, 31) étant disposés sur un substrat (10) commun.

2. Système gradiométrique selon la revendication 1, dans lequel la largeur des rubans des systèmes stratifiés est sélectionnée de telle sorte que les différentes parties de mesure des différents gradiomètres forment une partie globale de mesure du système gradiométrique.

3. Système gradiométrique selon la revendication 1, présentant un premier pont gradiométrique (30) doté d'au moins quatre premiers systèmes magnétoréstifs stratifiés (5) raccordés en pont de Wheatstone, dont au moins certaines parties de chacun, vues en plan, sont configurées comme ruban (16) présentant une première largeur (b), un deuxième pont gradiométrique (31) qui présente en particulier quatre deuxièmes systèmes magnétorésistifs stratifiés raccordés en pont de Wheatstone dont au moins certaines parties de chacun, vues en plan, sont configurées comme ruban d'une deuxième largeur différente de la largeur (b) des premiers rubans et un troisième pont gradiométrique (32) qui présente en particulier quatre systèmes magnétorésistifs stratifiés raccordés en pont de Wheatstone dont au moins certaines parties, vues en plan, sont configurées comme rubans qui présentent une troisième largeur différente de la largeur des premiers et des deuxièmes rubans, les ponts gradiométriques (30, 31, 32) étant disposés sur un substrat (10) commun.

4. Système gradiométrique selon la revendication 1, qui présente un premier pont gradiométrique (30) qui présente en particulier quatre premiers systèmes magnétorésistifs stratifiés (5) raccordés en pont de Wheatstone dont au moins certaines parties de chacun, vues en plan, sont configurées comme rubans (16) présentant une première largeur (b) et un deuxième pont gradiométrique (31) qui présente en particulier quatre deuxièmes systèmes magnétorésistifs stratifiés raccordés en pont de Wheatstone dont au moins certaines parties de chacun, vues en plan, sont configurées comme rubans d'une deuxième largeur différente de la largeur (b) des premiers rubans, les ponts gradiométriques (30, 31) étant disposés sur un substrat (10) commun.

5. Système gradiométrique selon la revendication 1, **caractérisé en ce que** les rubans présentent une largeur comprise dans la plage de 0,5 µm à 200 µm et en particulier de 1 µm à 100 µm.

6. Système gradiométrique selon la revendication 4, **caractérisé en ce que** la largeur (b) des premiers rubans est comprise entre 0,5 µm et 2 µm ou entre 8 µm et 15 µm et **en ce que** la largeur des deuxièmes rubans est comprise entre 3 µm et 7 µm.

7. Système gradiométrique selon la revendication 3, **caractérisé en ce que** la largeur (b) des premiers rubans est comprise entre 0,5µm et 2 µm, **en ce que** la largeur des deuxièmes rubans est comprise entre 8 µm et 15 µm et **en ce que** la largeur des troisièmes rubans est comprise entre 3 µm et 7 µm.

8. Système gradiométrique selon l'une des revendications précédentes, **caractérisé en ce qu'**il présente une unité commune d'évaluation électrique raccordée au système magnétorésistif stratifié et en particulier également disposé sur le substrat (10).

9. Système gradiométrique selon la revendication 1, **caractérisé en ce que** les systèmes magnétorésistifs stratifiés travaillent tous sur base de l'effet GMR ou de l'effet AMR en recourant à des multicouches couplées ou au principe dit "spin-valve".

10. Système gradiométrique selon la revendication 1, **caractérisé en ce que** chacun des systèmes stratifiés est configuré, vu en plan, au moins largement en forme de ruban et en particulier en forme de ruban en méandres.

11. Procédé de mesure de gradients de champ magnétique, doté d'un élément de détection et en particulier d'un système gradiométrique selon l'une des revendications précédentes, dans lequel plusieurs ponts gradiométriques (30, 31, 32) présentant des systèmes stratifiés sont formés sur un substrat commun, au moins certaines parties des systèmes stratifiés étant configurées en rubans, la largeur d'au moins deux des rubans d'au moins deux systèmes stratifiés de ponts gradiométriques différents les uns des autres étant différentes, les réglages différents de la largeur des rubans s'effectuant lors de leur formation de manière à obtenir pour les parties de mesure de l'élément de détection des gradients de champ magnétique une plage globale de mesure des différents ponts gradiométriques qui est supérieure aux parties distinctes de mesure des différents ponts gradiométriques.

12. Procédé selon la revendication 11, **caractérisé en ce que** pour augmenter la partie globale de mesure, on utilise au moins trois ponts gradiométriques dont les rubans ont des largeurs différentes les unes des autres et **en ce que** les différentes parties de mesure sont ajustées en adaptant la largeur des rubans de manière à obtenir la plage globale de mesure souhaitée.
